# FASCICULE DE BREVET EUROPEEN

(11) **EP 1 424 776 B1**
(45) Date de publication et mention de la délivrance du brevet: **22.02.2006**
(21) Numéro de dépôt: 02080009.0
(22) Date de dépôt: 28.11.2002
(51) Int. Cl.: H03L 5/00, H03B 5/12

(54) **Circuit oscillateur commandé en tension pour un dispositif électronique basse puissance**
Spannungsgesteuerte Oszillatorschaltung für eine elektronische Vorrichtung mit niedriger Leistung
Voltage controlled oscillator circuit for a low power electronic device

(43) Date de publication de la demande: 02.06.2004
(73) Titulaire: CSEM Centre Suisse d'Electronique et de Microtechnique S.A. - Recherche et Développement, 2007 Neuchâtel (CH)
(72) Inventeur: Ruffieux, David, 1782 Belfaux (CH)
(74) Mandataire: Ravenel, Thierry Gérard Louis

(56) Documents cités:
- US-B1- 6 268 777
- MARGARIT M A ET AL: "A LOW-NOISE, LOW-POWER VCO WITH AUTOMATIC AMPLITUDE CONTROL FOR WIRELESS APPLICATIONS" IEEE JOURNAL OF SOLID-STATE CIRCUITS, IEEE INC. NEW YORK, US, vol. 34, no. 6, juin 1999 (1999-06), pages 761-771, XP000913030 ISSN: 0018-9200
- ZANCHI A ET AL: "A 2-V 2.5-GHz - 104-dBc/Hz at 100 kHz Fully Integrated VCO with Wide-Band Low-Noise Automatic Amplitude Control Loop" IEEE JOURNAL OF SOLID-STATE CIRCUITS, IEEE INC. NEW YORK, US, vol. 36, no. 4, avril 2001 (2001-04), pages 611-619, XP002231063 ISSN: 0018-9200

## Description

L'invention concerne un circuit oscillateur commandé en tension notamment pour un dispositif électronique basse puissance, tel qu'un téléphone portable ou une montre. Ce circuit oscillateur commandé en tension peut faire partie d'un synthétiseur de fréquence. Il comprend notamment un circuit résonant, composé d'un élément capacitif variable en tension et d'au moins une inductance, qui est connecté à une paire de transistors couplés en croix, qui permet de compenser les pertes du circuit résonant.

Des circuits oscillateurs commandés en tension, dénommés VCO (Voltage Controlled Oscillator en terminologie anglaise), produisent principalement des signaux à haute fréquence. La fréquence de ces signaux à haute fréquence dépend généralement de la valeur capacitive d'un circuit résonant. Cette valeur capacitive est modifiée en fonction d'une tension de commande appliquée au condensateur variable dénommé varactor en terminologie anglaise. Dans le cas d'une utilisation dans un synthétiseur de fréquence, cette tension de commande filtrée provient d'un détecteur de phase d'une boucle à blocage de phase.

On rencontre de tels circuits oscillateurs par exemple dans des appareils portables de télécommunication pour la transmission d'information sur une fréquence porteuse qui peut être comprise entre quelques centaines de MHz à quelques GHz. Ces circuits oscillateurs peuvent également être utilisés pour des opérations de démodulation dans des récepteurs de signaux radiofréquences par exemple.

Comme ces circuits oscillateurs peuvent équiper des objets ou appareils portables, qui comprennent une pile ou un accumulateur de petite taille, il est souvent nécessaire de réduire leur consommation électrique, ainsi que leur tension d'alimentation.

Dans des circuits oscillateurs conventionnels, il est souvent nécessaire d'imposer un courant de polarisation de la paire de transistors suffisamment grand pour tenir compte du bruit de phase et du plus mauvais facteur de qualité du circuit résonant. Ceci implique une consommation électrique importante, ce qui est un inconvénient.

De multiples autres réalisations de circuits oscillateurs ont également été proposées de manière à limiter la consommation en courant. Le circuit oscillateur peut comprendre, par exemple, une boucle de régulation d'amplitude de manière à contrôler le courant nécessaire pour obtenir une amplitude d'oscillation suffisante. On peut citer à ce titre la publication intitulée "A Low-Noise, Low-Power VCO with Automatic Amplitude Control For Wireless Applications" de A. Mihai et al. et publiée dans la revue IEEE Journal of Solid-State Circuits, volume 34, n°6 de juin 1999 et la publication intitulée "A 2V 2.5GHz - 104dBc/Hz at 100kHz Fully Integrated VCO with Wide-Band Low-Noise Automatic Amplitude Control Loop" de A. Zanchi, C. Samori, S. Levantino et A. L. Lacaita, et publiée dans la revue IEEE Journal Of Solid-State Circuits, volume 36, n°4 d'avril 2001. Dans cette dernière publication, il est décrit un circuit oscillateur commandé en tension qui comprend une boucle de commande automatique d'amplitude d'oscillations.

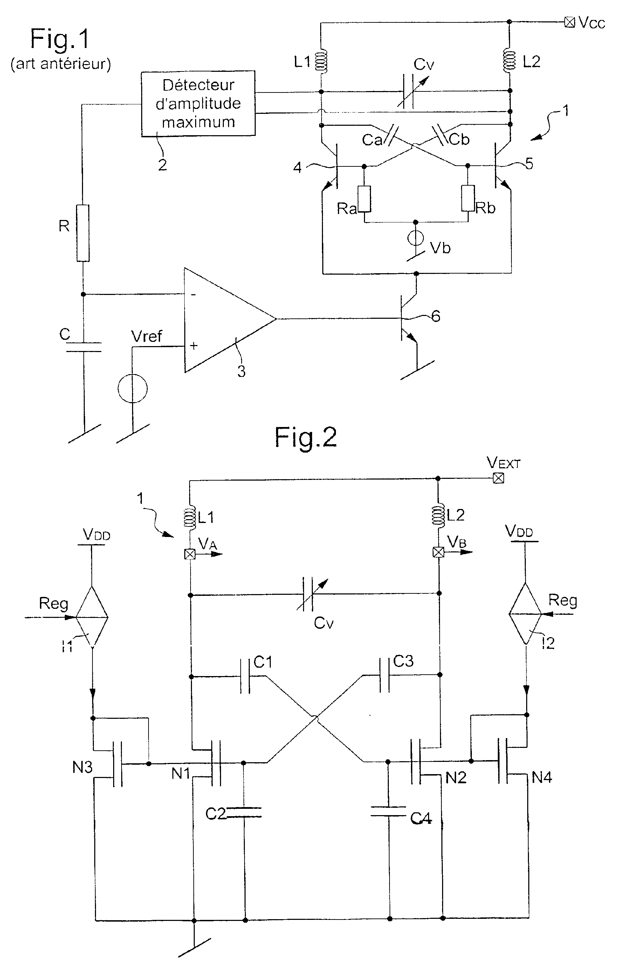

Ce circuit oscillateur, décrit dans la publication susmentionnée, est représenté de manière schématique sur la figure 1. Le circuit oscillateur 1 comprend une paire différentielle de transistors bipolaires couplés en croix 4 et 5, qui est connectée à un circuit résonant. Le circuit résonant est constitué par au moins un condensateur Cv et deux inductances L1 et L2, qui sont connectées à une borne de potentiel haut V_{CC} d'une source de tension. La base de chaque transistor 4 et 5 est couplée par des capacités Ca et Cb au collecteur de l'autre transistor. Une polarisation des transistors 4 et 5 est imposée par une source de tension Vb par l'intermédiaire de deux résistances Ra et Rb reliées à la base des transistors 4 et 5, respectivement. La paire différentielle des transistors couplés en croix permet de fournir une transconductance négative au circuit résonant. La transconductance négative compense la conductance de perte du circuit résonant pour obtenir des signaux oscillants.

Une source de courant variable est représentée par le transistor 6 placé en série avec la paire différentielle et le circuit résonant. Un détecteur d'amplitude 2 détecte l'amplitude maximale des oscillations sur les collecteurs des transistors 4 et 5. De plus, un filtre constitué par la résistance R et le condensateur C permet de retirer la tension en mode commun à comparer dans un amplificateur 3 avec une tension de référence Vref. Ainsi, lorsque l'amplitude des oscillations croît, la valeur du courant fourni par le transistor 6 diminue de manière à assurer une régulation d'amplitude.

Un inconvénient du circuit oscillateur proposé dans cette publication réside dans le fait que ie bruit engendré est important. Ce bruit est notamment dû à la source de courant placée en série avec le circuit résonant et la paire différentielle de transistors entre les bornes d'alimentation électrique.

Un autre inconvénient de ce circuit oscillateur est qu'il utilise un nombre important de composants pour réguler l'amplitude d'oscillations, ce qui implique une consommation électrique importante pour la régulation d'amplitude des oscillations et la génération de bruit supplémentaire.

Un but de l'invention est de pallier les inconvénients de l'art antérieur en fournissant un circuit oscillateur commandé en tension agencé de telle manière à minimiser le bruit et la consommation tout en maintenant une amplitude d'oscillation maximale.

A cet effet, l'objet de l'invention concerne un circuit oscillateur commandé en tension comprenant les caractéristiques mentionnées dans la revendication 1.

Des modes de réalisation avantageux de l'invention sont définis dans les revendications dépendantes.

Un avantage du circuit oscillateur, selon l'invention, réside en l'agencement des miroirs de courant, qui sont réalisés avec chaque transistor de la paire placé en parallèle avec un transistor respectif monté en diode. Chaque transistor monté en diode recevant un courant d'une source de courant de manière à polariser chaque transistor de la paire. En polarisant chaque transistor de la paire de cette façon, cela permet de réduire fortement le bruit engendré.

Grâce à la non-linéarité des transistors montés en diode, il peut être détecté une variation de tension en mode commun sur chaque borne de commande des transistors du miroir en fonction de la variation d'amplitude des signaux oscillants. Avantageusement, deux résistances connectées en série entre les bornes de commande des transistors de la paire peuvent extraire, par leur noeud de connexion, la tension en mode commun afin de la stocker sur un condensateur de filtrage. Plus l'amplitude des signaux oscillants croît, plus la tension en mode commun diminue, et inversement. La valeur de chaque courant fourni aux transistors montés en diode dépend directement de la variation de la tension en mode commun stockée sur le condensateur de filtrage. Ainsi, le courant diminue si l'amplitude des signaux oscillants augmente de manière à réduire également la consommation électrique du circuit oscillateur.

L'amplitude des signaux oscillants est donc limitée par la valeur du courant de polarisation, et non par des non-linéarités de la partie fournissant les signaux oscillants.

Les buts, avantages et caractéristiques du circuit oscillateur commandé en tension apparaîtront mieux dans la description suivante de formes d'exécution illustrées par les dessins sur lesquels :
- la figure 1 déjà citée représente un circuit oscillateur commandé en tension de l'art antérieur,
- la figure 2 représente de manière schématique le principe de régulation d'amplitude du circuit oscillateur commandé en tension selon l'invention,
- la figure 3 représente en détail une première forme d'exécution du circuit oscillateur commandé en tension selon l'invention, et
- la figure 4 représente une seconde forme d'exécution du circuit oscillateur commandé en tension selon l'invention.

La figure 2 montre de manière générale les composants électroniques du circuit oscillateur commandé en tension 1 selon une première forme d'exécution de la présente invention. Ce circuit oscillateur est de préférence utilisé dans un dispositif électronique basse puissance, tel qu'un téléphone portable ou une montre par exemple, sans toutefois être limité à l'emploi uniquement dans un tel dispositif basse puissance. Lorsqu'il fait partie d'un synthétiseur de fréquence, il produit des signaux oscillants haute fréquence sur lesquels sont par exemple modulés des signaux de données. La fréquence porteuse des signaux oscillants est ajustée par une tension continue de commande appliquée sur une entrée du circuit oscillateur.

Ce circuit oscillateur commandé en tension 1 comprend principalement, dans un agencement en série entre une borne de potentiel haut V_{EXT} et une borne de potentiel bas d'une source de tension régulée, un circuit résonant, qui est constitué par deux inductances L1 et L2 et d'un élément capacitif variable Cv, et une paire de transistors NMOS couplés en croix N1 et N2 pour compenser des pertes du circuit résonant. La paire de transistors NMOS est connectée entre des bornes de sortie V_{A} et V_{B} de signaux oscillants du circuit résonant, et une borne de potentiel bas de la tension régulée, qui constitue la masse.

La première inductance L1 est connectée entre la borne V_{EXT} et la borne V_{A}, alors que la seconde inductance L2 est connectée entre la borne V_{EXT} et la borne V_{B.} L'élément capacitif Cv, qui représente un varacteur, est connecté entre les bornes V_{A} et V_{B} du circuit résonant. La valeur capacitive de cet élément capacitif varie en fonction d'une tension continue de commande appliquée sur une entrée de l'élément capacitif, non représentée. La variation de la valeur capacitive permet de modifier la fréquence de deux signaux oscillants en opposition de phase fournis, respectivement, sur les première et seconde bornes de sortie V_{A} et V_{B.}

Chaque transistor NMOS N1 et N2 comprend une borne de commande, qui est la grille, et des première et seconde bornes de courant, qui sont le drain et la source. Le drain du premier transistor N1 de la paire est connecté à la borne de sortie V_{A}, alors que le drain du second transistor N2 de la paire est connecté à la borne de sortie V_{B}. La grille du premier transistor N1 est reliée au drain du second transistor N2 par l'intermédiaire d'un condensateur de couplage C3, alors que la grille du second transistor N2 est reliée au drain du premier transistor N1 par l'intermédiaire d'un condensateur de couplage C1. Les sources des deux transistors N1 et N2 sont reliées à la borne de potentiel bas de la source de tension régulée. Par cette connexion croisée des grilles de chaque transistor de la paire, une transconductance négative est créée de manière à compenser entièrement les pertes du circuit résonant.

De manière générale, le circuit résonant peut être représenté par la mise en parallèle d'une inductance, d'un condensateur variable et d'une conductance de perte. Ainsi, il est nécessaire que la transconductance négative mise en parallèle des éléments du circuit résonant soit supérieure à la conductance parallèle de perte en phase de démarrage du circuit oscillateur. Une fois, que l'amplitude maximale des signaux oscillants est stabilisée, la transconductance négative et la conductance de perte sont égales.

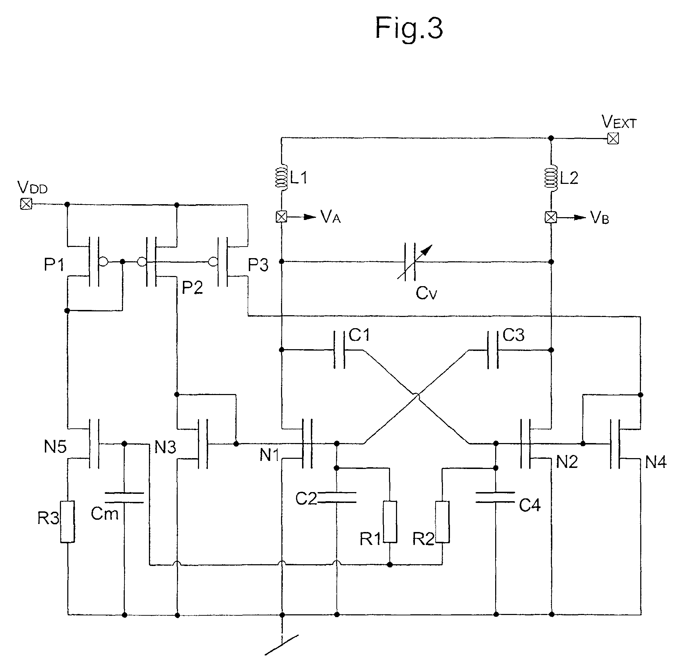

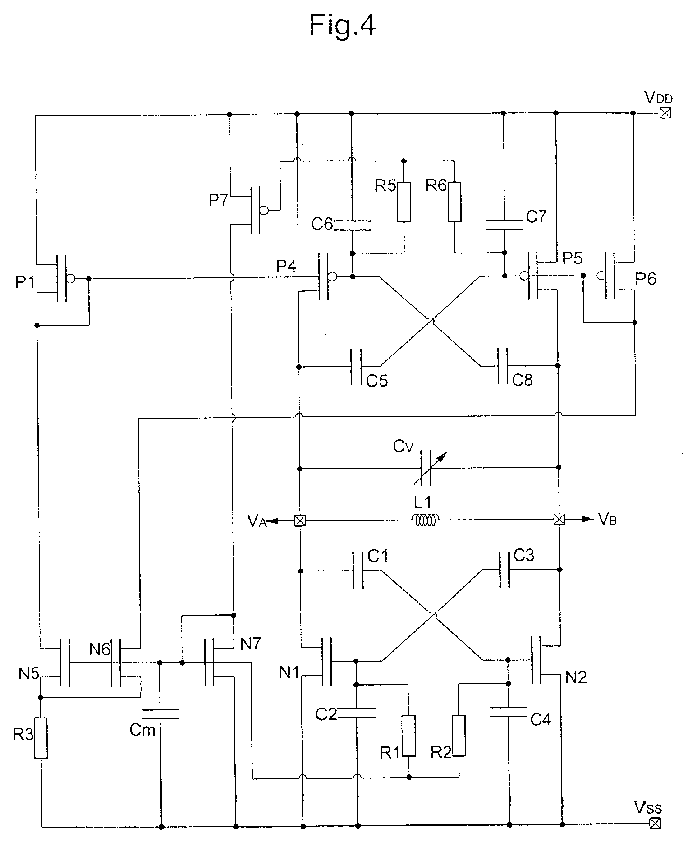

Comme un but de la présente invention est de réduire le bruit engendré.et la consommation du circuit tout en garantissant une amplitude maximale des signaux oscillants, chaque transistor de la paire, N1 et N2, est connecté en parallèle avec un transistor NMOS, N3 et N4, monté en diode. Le premier transistor monté en diode N3, respectivement le second transistor monté en diode N4, reçoivent chacun un courant produit par une première source de courant variable I1, respectivement par une seconde source de courant variable 12. De cette manière, le transistor N1 de la paire et le transistor monté en diode N3 forme un premier miroir de courant, alors que le transistor N2 de la paire et le transistor monté en diode N4 forme un second miroir de courant. Le courant produit par chaque source de courant est commandé par un signal de régulation Reg de manière à diminuer la valeur du courant lorsqu'il est détecté une augmentation du niveau d'amplitude des signaux oscillants, et inversement. De ce fait, la valeur du courant en phase de démarrage du circuit oscillateur est plus grand que la valeur du courant quand l'amplitude des signaux oscillants est maximale. Dans la suite de la description en référence aux figures 3 et 4, il sera expliqué de manière plus détaillée comment le courant de chaque source de courant est ajusté en fonction du niveau détecté d'amplitude des signaux oscillants. C'est principalement par la non-linéarité de chaque transistor monté en diode, N3 et N4, de chaque miroir de courant, qu'il est possibie d'extraire ie signai de régulation des sources de courant. Plus le niveau d'amplitude des signaux oscillants augmente, plus la tension en mode commun, vue sur les grilles des transistors NMOS, a tendance à baisser grâce à la non-linéarité des transistors N3 et N4 montés en diode.

Il est à noter que la dimension de chaque transistor NMOS N1 et N2 de la paire est de préférence K fois plus grande que la dimension de chaque transistor N3 et N4 monté en diode, K étant un nombre entier supérieur à 1. La valeur de courant imposé dans chaque transistor N1 et N2 de la paire est donc environ K fois supérieur à celui fourni par chaque source de courant 11 et 12. De plus, le courant moyen circulant dans chaque transistor de la paire est approximativement le même.

De manière à diviser la tension de commande sur les grilles des transistors de la paire N1 et N2, un premier diviseur de tension est constitué par le condensateur de couplage C1 et le condensateur C4, qui est relié entre la grille du transistor N1 et la borne de potentiel bas, et un second diviseur de tension est constitué par le condensateur de couplage C3 et le condensateur C2, qui est relié entre la grille du transistor N2 et la borne de potentiel bas. Ainsi, l'amplitude des signaux oscillants vue par la grille de chaque transistor N1 et N2 peut être divisée par le facteur (C1+C4)/C1 ou le facteur (C3+C2)/C3. Les deux facteurs de division sont égaux. Ceci permet d'avoir en sortie une large amplitude des signaux oscillants tout en minimisant l'amplitude des signaux appliqués sur les grilles des transistors N1 et N2 et, par suite, le bruit engendré par ces derniers. De préférence, les transistors peuvent fonctionner en faible inversion, ce qui a tendance à augmenter la valeur de la transconductance négative. Toutefois, il peut aussi être prévu de faire fonctionner les transistors du circuit oscillateur en forte inversion.

Le circuit oscillateur peut être alimenté par une source de tension constituée par une pile ou un accumulateur dont la valeur de tension peut fluctuer par exemple entre 1,5V à 0,9V en fin de vie de la pile. De ce fait, il peut être prévu de brancher la partie générant les oscillations du circuit oscillateur à une source de tension régulée, non représentée. La valeur de cette tension régulée peut être fixée par exemple à 0,9V, ou même à la moitié de cette valeur, en fonction de la tension nominale de la technologie (par exemple TSMC à 0.18 *µ*m) employée pour réaliser le circuit oscillateur. La partie de génération des sources de courant peut être connectée directement aux bornes de la source d'alimentation, qui peut être une pile. Le niveau d'amplitude maximale des signaux oscillants peut donc être légèrement inférieur à 0,9V autour de la tension régulée V_{EXT,} c'est-à-dire que l'amplitude crête à crête des signaux oscillants est proche de 1,6V.

Une première forme d'exécution du circuit oscillateur commandé en tension selon l'invention est présentée à la figure 3. Il est à noter que les éléments de cette figure, qui correspondent à ceux décrits en référence à la figure 2, portent des signes de référence identiques.

Le circuit oscillateur de cette première forme d'exécution comprend les mêmes éléments qui ont été décrits en référence à la figure 2. Ce circuit oscillateur comprend donc le circuit résonant, constitué par les inductances L1 et L2 et l'élément capacitif variable Cv, la paire de transistors NMOS N1 et N2 couplés en croix, les transistors NMOS N3 et N4 montés en diode et les diviseurs capacitifs C1, C4 et C3, C2. Par contre, les éléments de la boucle de réglage d'amplitude vont être décrits de manière plus détaillée.

Dans la boucle de réglage d'amplitude, la variation du niveau d'amplitude des signaux oscillants est détectée par deux résistances R1 et R2, qui sont branchées en série entre les grilles des transistors NMOS N1 et N2, et un condensateur de filtrage Cm, qui est branché au noeud de connexion des deux résistances et à la borne de potentiel bas de la source de tension d'alimentation. Ainsi, une tension en mode commun, qui est le reflet de la tension moyenne de grille des transistors de la paire, peut être captée sur le condensateur de filtrage Cm. Cette tension en mode commun diminue si l'amplitude des signaux oscillants augmente, et inversement, car les transistors NMOS N3 et N4 montés en diode ont un comportement non-linéaire.

Le condensateur de filtrage Cm est connecté à la grille d'un transistor NMOS N5 de référence, dont la source est reliée à la borne de potentiel bas, c'est-à-dire à la borne de masse, par l'intermédiaire d'une résistance R3 de référence. C'est cette résistance R3 qui va déterminer la valeur du courant de chaque source de courant en fonction de la tension en mode commun captée sur le condensateur de filtrage. La dimension du transistor NMOS N5 doit être M fois plus grande que celle des transistors N3 et N4, où M est un nombre entier supérieur à 1. Ainsi la valeur du courant de référence dépend en partie du logarithme naturel de M, de la valeur de la résistance de référence R3, ainsi que de la tension en mode commun détectée sur le condensateur de filtrage Cm.

Le drain du transistor NMOS N5 fournit un courant de référence à un transistor PMOS P1 monté en diode d'un troisième miroir de courant. Ce troisième miroir de courant, qui est constitué de transistors PMOS, est connecté à une borne de potentiel haut d'une source de tension d'alimentation V_{DD.} Deux autres transistors PMOS P2 et P3 du troisième miroir de courant sont connectés, par leur grille, en parallèle au transistor PMOS P1 monté en diode, de manière à dupliquer le courant de référence. Le drain du transistor PMOS P2, qui agit comme une source de courant, fournit le courant au transistor NMOS N3 monté en diode. Le transistor PMOS P3 fournit le courant au transistor NMOS N4 monté en diode. De cette manière, ie courant fourni à chaque transistor NMOS N3 et N4 montés en diode est dépendant directement du niveau détecté d'amplitude des signaux oscillants. Ainsi, par cet agencement, l'amplitude des signaux oscillants peut être automatiquement régulée grâce à la valeur du courant fourni à chaque transistor NMOS N3 et N4.

Il est à noter que la boucle, constituée par les transistors NMOS N3, N4 et N5, les transistors PMOS P1, P2 et P3, et la résistance de référence R3, est proportionnelle à la température absolue (PTAT).

Dans l'idée de cette première forme d'exécution, il aurait pu être imaginé une configuration inversée en utilisant une paire de transistors PMOS branchés à la borne de potentiel haut d'une source de tension. Dans ce cas, le circuit résonant est connecté entre la paire de transistors PMOS et la borne de masse. Un transistor PMOS monté en diode doit être connecté à chaque transistor PMOS de la paire. Le transistor de référence est également un transistor PMOS connecté à la borne de potentiel haut de la source de tension par l'intermédiaire de la résistance de référence. Ce transistor de référence est polarisé par la tension en mode commun extraite par deux résistances branchées en série entre les grilles des transistors PMOS de la paire, et stockée sur le condensateur de filtrage. Ce condensateur de filtrage est connecté entre la grille du transistor de référence PMOS et la borne de potentiel haut. Les sources de courant pour chaque transistor PMOS monté en diode sont réalisées à l'aide d'un miroir de courant constitué de transistors NMOS connecté à la borne de masse.

Une seconde forme d'exécution du circuit oscillateur commandé en tension selon l'invention est présentée à la figure 4. Il est à noter que les éléments de cette figure, qui correspondent à ceux décrits en référence aux figures 2 et 3, portent des signes de référence identiques.

Ce circuit oscillateur comprend, dans un agencement série entre les bornes V_{DD} et V_{SS} d'une source de tension d'alimentation, une première paire de transistors PMOS couplés en croix P4 et P5, un circuit résonant, et une seconde paire de transistors NMOS couplés en croix N1 et N2. Le circuit résonant comprend une inductance L1 en parallèle à l'élément capacitif variable Cv entre les deux bornes de sortie V_{A} et V_{B.} La grille de chaque transistor des deux paires est reliée par l'intermédiaire d'un condensateur de couplage C1, C3, C5, C8 au drain de l'autre transistor de la même paire.

De manière à diviser la tension des signaux oscillants pour fournir une tension de commande sur chaque grille des transistors des deux paires, chaque condensateur de couplage fait partie d'un diviseur capacitif de tension. C'est ainsi qu'un premier diviseur de tension est constitué par le condensateur de couplage C1 et le condensateur C4, qui est relié entre la grille du transistor N1 et la borne V_{SS}. Un second diviseur de tension est constitué par le condensateur de couplage C3 et le condensateur C2, qui est relié entre la grille du transistor N2 et la borne V_{SS}. Un troisième diviseur de tension est constitué par le condensateur de couplage C5 et le condensateur C7, qui est relié entre la grille du transistor P5 et la borne V_{DD}. Un quatrième diviseur de tension est constitué par le condensateur de couplage C8 et le condensateur C6, qui est relié entre la grille du transistor P4 et la borne V_{DD}. Ainsi, l'amplitude des signaux oscillants vue par la grille de chaque transistor P4, P5, N1 et N2 peut être divisée par le facteur (C1+C4)/C1, le facteur (C3+C2)/C3, le facteur (C5+C7)/C5 ou le facteur (C8+C6)/C8. Les quatre facteurs de division sont égaux. Ces diviseurs capacitifs offrent le même avantage que celui mentionné avec la figure 2.

Un transistor PMOS P1 monté en diode est connecté en parallèle au transistor PMOS P4 de la paire pour former un premier miroir de courant. Le transistor PMOS P6 monté en diode est connecté en parallèle au transistor P5 de la paire pour former un second miroir de courant. Le transistor PMOS P1 monté en diode reçoit un courant provenant d'un premier transistor de référence NMOS N5, alors que le transistor PMOS P6 reçoit un courant provenant d'un second transistor de référence NMOS N6. Les deux transistors de référence N5 et N6 sont connectés en parallèle et ont leur source reliée à la borne V_{SS}, c'est-à-dire à la borne de masse, par l'intermédiaire d'une résistance R3 de référence.

Comme pour la première forme d'exécution, la variation du niveau d'amplitude des signaux oscillants peut être mesurée grâce à la non-linéarité des transistors PMOS P1 et P6 montés en diode. Dans la boucle de réglage d'amplitude, cette variation du niveau d'amplitude des signaux oscillants est détectée notamment par deux résistances R5 et R6, qui sont branchées en série entre les grilles des transistors PMOS P4 et P5. Le noeud de connexion des deux résistances R5 et R6, est relié par un agencement de transistors de renvoi P7 et N7 à un condensateur de filtrage Cm pour fournir la tension en mode commun détectée. Le transistor de renvoi PMOS P7, dont la source est reliée à la borne V_{DD}, a sa grille connectée directement au noeud de connexion des deux résistances R5 et R6. Le drain de ce transistor PMOS P7 est relié à un transistor NMOS N7 monté en diode, dont la source est reliée à la borne V_{SS.} Ce transistor de renvoi NMOS N7 monté en diode fournit la tension en mode commun stockée sur le condensateur de filtrage Cm. Ceci permet au condensateur Cm de polariser les transistors de référence N5 et N6 pour déterminer ia valeur des courants de référence en fonction du niveau de cette tension en mode commun.

Les transistors NMOS N1 et N2 de la seconde paire sont polarisés par l'intermédiaire de deux autres résistances R1 et R2. Ces deux résistances R1 et R2 sont branchées en série entre les grilles des transistors NMOS N1 et N2. Le noeud de connexion des résistances R1 et R2 est relié au condensateur de filtrage Cm. Lorsque des signaux oscillants apparaissent aux bornes de sortie V_{A}, V_{B}, la linéarité des résistances R1 et R2 assure que le courant moyen tiré par la seconde paire de transistors NMOS N1 et N2 est identique au courant moyen issu de la première paire de transistors PMOS P4 et P5. Comme le facteur de division de chaque diviseur est identique, les deux paires de transistors PMOS et NMOS participent de manière égale à la création des signaux oscillants.

Comme précédemment, la dimension de chaque transistor PMOS P4 et P5 de la première paire, et chaque transistor NMOS N1 et N2 de la seconde paire est de préférence K fois plus grande que la dimension de chaque transistor PMOS P1 et P6 montés en diode, K étant un nombre entier supérieur à 1. La valeur du courant créé dans chaque transistor PMOS P4 et P5 de la première paire est donc environ K fois supérieure à celle du courant fourni par chaque transistor de référence N5 et N6. De même, la dimension des transistors de référence N5 et N6 doit être supérieure à celle du transistor de renvoi NMOS N7 monté en diode. De cette façon, les courants de référence, polarisant chaque transistor PMOS P1 et P6 montés en diode, dépendent de la valeur de la résistance R3, du rapport dimensionnel entre le transistor NMOS N7 et les transistors de référence NMOS N5 et N6, et de la tension en mode commun stockée sur le condensateur Cm.

Dans cette seconde forme d'exécution du circuit oscillateur, la partie du circuit fournissant les signaux oscillants en opposition de phase est alimentée directement par les bornes V_{SS} et V_{DD} à une source de tension d'alimentation. L'amplitude maximale des signaux oscillants peut être légèrement inférieure à la tension de la source d'alimentation. Pour une tension d'alimentation proche de 1,8V, l'amplitude des oscillations crête à crête peut être régulée par construction jusqu'à une valeur de 1,6V de manière à ne pas dé-saturer le drain de n'importe quel transistor des paires.

Ce dernier circuit présente l'avantage de consommer deux fois moins de puissance que le précédent circuit pour un même niveau d'amplitude des signaux oscillants. Il est, cependant, mieux adapté à une source de tension fixe d'alimentation à V_{DD} nominal.

Le circuit résonant des deux formes d'exécution doit, si possible, avoir un facteur de qualité Q important, car cela a une influence directe sur le produit de la puissance consommée par ie bruit, qui est à minimiser dans une application à des systèmes portables. De ce fait, il est préférable d'utiliser des inductances L1 et L2 externes, car le facteur de qualité Q d'une inductance intégrée avec tous les autres composants du circuit oscillateur est en général relativement faible.

A partir de la description qui vient d'être faite, de multiples variantes de réalisation du circuit oscillateur commandé en tension peuvent être conçues par l'homme du métier sans sortir du cadre de l'invention définie par les revendications. Il peut être prévu de remplacer les transistors MOS par des transistors bipolaires ou d'un autre type.

## Revendications

1. Circuit oscillateur (1) commandé en tension notamment pour un dispositif électronique basse puissance, le circuit oscillateur comprenant :
- un circuit résonant muni d'au moins une inductance (L1, L2) et d'un élément capacitif (Cv) dont la valeur capacitive varie en fonction d'une tension de commande appliquée sur une entrée de l'élément capacitif pour ajuster la fréquence de deux signaux oscillants en opposition de phase qui sont fournis respectivement par une première et une seconde bornes de sortie (V_{A}, V_{B}) du circuit résonant,
- au moins une paire de transistors couplés en croix (N1, N2, P4, P5), qui est connectée au circuit résonant pour compenser des pertes du circuit résonant, les transistors comprenant chacun une borne de commande et une première et une seconde bornes de courant, la première borne de courant du premier transistor (N1, P4), respectivement du second transistor (N2, P5), étant connectée à la première borne de sortie (V_{A}), respectivement à la seconde borne de sortie (V_{B}), du circuit résonant alors que la borne de commande de chaque transistor est connectée par l'intermédiaire d'un condensateur de couplage (C1, C3) à la première borne de courant de l'autre transistor,
**caractérisé en ce que** chaque transistor de la paire est connecté en parallèle à un transistor monté en diode (N3, N4, P1, P6), qui est traversé par un courant fourni par une source de courant (I1, I2), chaque transistor de la paire et le transistor correspondant monté en diode formant un miroir de courant pour imposer au circuit résonant un courant moyen de manière à fournir des signaux oscillants à une amplitude maximale dépendant du dimensionnement dé certains éléments dudit circuit.

2. Circuit oscillateur selon ia revendication i, **caractérisé en ce qu'**il comprend une boucle de réglage d'amplitude des signaux oscillants dans laquelle la valeur du courant de la source de courant (I1, I2) de chaque miroir de courant varie en fonction du niveau détecté d'amplitude des signaux oscillants, la valeur du courant diminuant, respectivement augmentant, lors d'un accroissement, respectivement lors d'une diminution du niveau d'amplitude des signaux oscillants.

3. Circuit oscillateur selon la revendication 2, **caractérisé en ce que** la boucle de réglage d'amplitude comprend notamment deux résistances (R1, R2, R5, R6) branchées en série entre les bornes de commande des transistors de la paire, et un condensateur de filtrage (Cm), dont une première électrode est branchée directement ou par un agencement de transistors de renvoi (P7, N7) au noeud de connexion des deux résistances, et une seconde électrode est branchée à une borne de potentiel haut ou bas d'une source de tension, un niveau de tension en mode commun, qui dépend du niveau d'amplitude des signaux oscillants, étant capté sur la première électrode du condensateur de filtrage par l'intermédiaire du noeud de connexion des résistances, pour déterminer la valeur de courant des sources de courant.

4. Circuit oscillateur selon la revendication 3, **caractérisé en ce que** la valeur du courant des sources de courant dans la boucle de réglage d'amplitude est définie par une résistance de référence (R3), qui est connectée à une borne de courant d'au moins un transistor de référence (N5, N6), une borne de commande du transistor de référence étant connectée à la première électrode du condensateur de filtrage (Cm) de manière à placer la résistance de référence et le transistor de référence en parallèle au condensateur de filtrage, le transistor de référence étant polarisé par la tension en mode commun captée par le condensateur de filtrage.

5. Circuit oscillateur selon l'une des revendications précédentes, **caractérisé en ce que** le circuit résonant (L1, L2, Cv) et la paire de transistors couplés en croix (N1, N2) sont agencés en série entre une borne de potentiel haut (V_{EXT}) et une borne de potentiel bas d'une source de tension régulée, la seconde borne de courant de chaque transistor de la paire et du transistor correspondant (N3, N4) monté en diode étant connectée directement à la borne de potentiel haut ou à la borne de potentiel bas de la source de tension régulée, et **en ce que** le circuit résonant comprend deux inductances (L1, L2) connectées chacune à une borne de sortie respective du circuit résonant et à la borne de potentiel opposée à la borne de potentiel connectant la seconde borne de courant des transistors, l'élément capacitif variable (Cv) étant connecté entre les deux bornes de sortie du circuit résonant.

6. Circuit oscillateur selon la revendication 5, **caractérisé en ce que** la paire de transistors couplés en croix (N1, N2), ainsi que chaque transistor (N3, N4) monté en diode connecté à un transistor correspondant de la paire, sont des transistors de type NMOS, dont la source est reliée directement à une borne de potentiel bas d'une source de tension régulée, et **en ce que** le transistor de référence (N5) est un transistor NMOS dont la source est reliée à la résistance de référence (R3), qui est reliée à une borne de potentiel bas d'une source de tension, et le drain fournit un courant de référence à un transistor PMOS (P1) monté en diode d'un second miroir de courant, qui est connecté à une borne de potentiel haut d'une source de tension d'alimentation (V_{DD}), deux autres transistors PMOS (P2, P3) du second miroir de courant étant connectés en parallèle au transistor PMOS monté en diode de manière à dupliquer le courant de référence pour fournir chacun un courant aux transistors NMOS montés en diode, la valeur du courant dépendant du niveau détecté d'amplitude des signaux oscillants.

7. Circuit oscillateur selon l'une des revendications 1 à 4, **caractérisé en ce qu'**il comprend une première et une seconde paires de transistors couplés en croix de type différent, la borne de commande de chaque transistor des deux paires étant reliée par l'intermédiaire d'un condensateur de couplage (C1, C3, C5, C8) à la première borne de courant de l'autre transistor de la paire, et **en ce que** le circuit résonant, qui comprend entre les deux bornes de sortie (V_{A}, V_{B}) une inductance (L1) en parallèle à l'élément capacitif (Cv), est placé entre les deux paires de transistors (N1, N2, P4, P5), la seconde borne de courant de chaque transistor de la première paire étant connectée à une borne de potentiel bas (V_{SS}), alors que la seconde borne de courant de chaque transistor de la seconde paire est connectée à une borne de potentiel haut (V_{DD}) d'une source de tension d'alimentation.

8. Circuit oscillateur selon la revendication 7, **caractérisé en ce que** la première paire de transistors couplés en croix (P4, P5), ainsi que chaque transistor monté en diode (P1, P6) connecté à un transistor correspondant de la première paire, sont des transistors de type PMOS, dont la source est reliée directement à une borne de potentiel haut (V_{DD}) de la source de tension d'alimentation, et **en ce que** la seconde paire de transistors couplés en croix sont des transistors de type NMOS, dont la source est reliée directement à une borne de potentiel bas (Vss) de la source de tension.

9. Circuit oscillateur selon la revendication 8, **caractérisé en ce qu'**il comprend deux transistors de référence (N5, N6) en parallèle, les transistors de référence étant des transistors NMOS dont la source est reliée à la résistance de référence (R3), qui est reliée à une borne de potentiel bas d'une source de tension, et le drain de chaque transistor de référence fournit un courant de référence au transistor PMOS respectif (P1, P6) monté en diode, **en ce que** le noeeud de connexion des deux résistances (R5, R6) branchées en série entre les grilles des transistors de la première paire est relié à une grille d'un transistor PMOS (P7) de renvoi, dont la source est reliée directement à la borne de potentiel haut de la source de tension, et le drain est connecté à un transistor NMOS (N7) de renvoi monté en diode, la source de ce transistor NMOS étant reliée directement à la borne de potentiel bas de la source de tension, **en ce que** le drain et la grille du transistor NMOS de renvoi sont connectés à la première électrode du condensateur de filtrage (Cm) et aux grilles des transistors de référence (N5, N6), et **en ce que** deux autres résistances (R1, R2) sont branchées en série entre les bornes de commande des transistors NMOS de la seconde paire, le noeud de connexion de ces résistances étant relié à la première électrode du condensateur de filtrage (Cm) pour servir à polariser les transistors NMOS de la seconde paire.

10. Circuit oscillateur selon l'une des revendications précédentes, **caractérisé en ce que** chaque condensateur de couplage (C1, C3, C5, C8) des bornes de commande des transistors de chaque paire fait partie d'un diviseur capacitif par transistor de chaque paire, pour diviser la tension des signaux oscillants à fournir sur les bornes de commande des transistors de chaque paire.

## Claims

1. Voltage controlled oscillator circuit (1) particularly for a low power electronic device, the oscillator circuit including:
- a resonant circuit provided with at least one inductive element (L1, L2) and a capacitive element (C_{V}) whose capacitive value varies as a function of a control voltage applied across a capacitive element to adjust the frequency of two oscillating signals in phase opposition which are respectively supplied by a first and a second output terminals (V_{A}, V_{B}) of the resonant circuit,
- at least one pair of cross-coupled transistors (N1, N2, N3, N4), which is connected to the resonant circuit to compensate for the resonant circuit losses, the transistors each including a control terminal and a first and second current terminals, the first current terminal of the first transistor (N1, P4) or respectively of the second transistor (N2, P5) being connected to the first output terminal (V_{A}) or respectively the second output terminal (V_{B}) of the resonant circuit, whereas the control terminal of each transistor is connected via a coupling capacitor (C1, C3) to the first current terminal of the other transistor,
**characterized in that** each transistor of the pair is connected in parallel to a diode mounted transistor (N3, N4, P1, P6), through which a current, supplied by a current source passes (I1, I2), each transistor of the pair and the corresponding diode mounted transistor forming a current mirror to impose a mean current on the resonant circuit so as to supply oscillating signals at a maximum amplitude depending on the sizing of certain elements of said circuit.

2. Oscillator circuit according to claim 1, **characterized in that** it includes an oscillating signal amplitude regulation loop in which the current value of the current source (I1, I2) of each current mirror varies as a function of the detected oscillating signal amplitude level, the current value decreasing or respectively increasing, when there is an increase or respectively a decrease in the oscillating signal amplitude level.

3. Oscillator according to claim 2, **characterized in that** the amplitude regulation loop includes in particular two resistors series (R1, R2, R5, R6) connected between the control terminals of the transistors of the pair, and a filtering capacitor (Cm), whose first electrode is connected directly or via an arrangement of return transistors (P7, N7), to the connection node of the two resistors, and whose second electrode is connected to a high or low potential terminal of a voltage source, a common mode voltage level, which depends on the oscillating signal amplitude level, being picked up across the first electrode of the filtering capacitor via the connection node of the resistors, to determine the current value of the current sources.

4. Oscillator circuit according to claim 3, **characterized in that** the current value of the current sources in the amplitude regulation loop is defined by a reference resistor (R3), which is connected to a current terminal of at least one reference transistor (N5, N6), a control terminal of the reference transistor being connected to the first electrode of the filtering capacitor (Cm) so as to place the reference resistor and the reference transistor in parallel to the filtering capacitor, the reference transistor being biased by the common mode voltage picked up by the filtering capacitor.

5. Oscillator circuit according to any of the preceding claims, **characterized in that** the resonant circuit (L1, L2, C_{V}) and the pair of cross-coupled transistors (N1, N2) are arranged in series between a high potential terminal (V_{EXT}) and a low potential terminal of a regulated voltage source, the second current terminal of each transistor of the pair and of the corresponding diode mounted transistor (N3, N4) being directly connected to the high potential terminal or the low potential terminal of the regulated voltage source, and **in that** the resonant circuit includes two inductive elements (L1, L2) each connected to a respective output terminal of the resonant circuit and to the potential terminal opposite to the potential terminal connecting the second current terminal of the transistors, the variable capacitive element (C_{V}) being connected between the two output terminals of the resonant circuit.

6. Oscillator circuit according to claim 5, **characterized in that** the pair of cross-coupled transistors (N1, N2), and each diode mounted transistor (N3, N4) connected to a corresponding transistor of the pair, are NMOS type transistors, whose source is directly connected to a low potential terminal of a regulated voltage source, and **in that** the reference transistor (N5) is an NMOS type transistor whose source is connected to the reference resistor (R3), which is connected to a low potential terminal of a voltage source, and whose drain supplies a reference current to a diode mounted PMOS transistor (P1) of a second current mirror, which is connected to a high potential terminal of a supply voltage source (V_{DD}), two other PMOS transistors (P2, P3) of the second current mirror being connected in parallel to the diode mounted PMOS transistor so as to duplicate the reference current to each provide a current to the diode mounted NMOS transistors, the current value depending on the detected oscillating signal amplitude level.

7. Oscillator circuit according to any of claims 1 to 4, **characterized in that** it includes a first and second pairs of cross-coupled transistors of different types, the control terminal of each transistor of the two pairs being connected via a coupling capacitor (C1, C2, C5, C8) to the first current terminal of the other transistor of the pair, and **in that** the resonant circuit, which includes, between the two output terminals (V_{A}, V_{B}) an inductive element (L1) in parallel to the capacitive element (C_{V}), is placed between the two pairs of transistors (N1, N2, P4, P5), the second current terminal of each transistor of the first pair being connected to a low potential terminal (V_{SS})_{,} whereas the second current terminal of each transistor of the second pair is connected to a high potential terminal (V_{DD}) of a supply voltage source.

8. Oscillator circuit according to claim 7, **characterized in that** the first pair of cross-coupled transistors (P4, P5), and each diode mounted transistor (P1, P6) connected to a corresponding transistor of the first pair, are PMOS type transistors, whose source is directly connected to a high potential terminal (V_{DD}) of the supply voltage source, and **in that** the second pair of cross-coupled transistors are NMOS type transistors, whose source is directly connected to a low potential terminal (V_{SS}) of the voltage source.

9. Oscillator circuit according to claim 8, **characterized in that** it includes two parallel reference transistors (N5, N6), the reference transistors being NMOS transistors whose source is connected to the reference resistor (R3), which is connected to a low potential terminal of a voltage source, and the drain of each reference transistor supplies a reference current to the respective diode mounted PMOS transistor (P1, P6), **in that** the connection node of the two resistors (R5, R6) series connected between the gates of the transistors of the first pair is connected to a gate of a return PMOS transistor (P7), whose source is directly connected to the high potential terminal of the voltage source, and whose drain is connected to a diode mounted return NMOS transistor (N7), the source of this NMOS transistor being directly connected to the low potential terminal of the voltage source, **in that** the drain and the gate of the return NMOS transistor are connected to the first electrode of the filtering capacitor (Cm) and to the gates of the reference transistors, and **in that** two other resistors (R1, R2) are series connected between the control terminals of the NMOS transistors of the second pair, the connection node of these resistors being connected to the first electrode of the filtering capacitor (Cm) to be used to bias the NMOS transistors of the second pair.

10. Oscillator circuit according to any of the preceding claims, **characterized in that** each coupling capacitor (C1, C3, C5, C8) of the control terminals of the transistors of each pair forms part of a capacitive divider per transistor of each pair, for dividing the voltage of the oscillating signals to be supplied across the control terminals of the transistors of each pair.

## Patentansprüche

1. Spannungsgesteuerte Oszillatorschaltung (1) insbesondere für eine elektronische Niedrigleistungsvorrichtung, wobei die Oszillatorschaltung umfasst:
- eine Resonanzschaltung, die versehen ist mit wenigstens einer Induktivität (L1, L2) und mit einem kapazitiven Element (Cv), dessen kapazitiver Wert sich in Abhängigkeit von einer an einen Eingang das kapazitiven Elements angelegten Steuerspannung ändert, um die Frequenz von zwei gegenphasigen oszillierenden Signalen einzustellen, die von einem ersten bzw. einem zweiten Ausgangsanschluss (V_{A}, V_{B}) der Resonanzschaltung geliefert werden,
- wenigstens ein Paar kreuzgekoppelter Transistoren (N1, N2, P4, P5), die mit der Resonanzschaltung verbunden sind, um Verluste der Resonanzschaltung zu kompensieren, wobei die Transistoren jeweils einen Steueranschluss sowie einen ersten und einen zweiten Stromanschluss besitzen, wobei der erste Stromanschluss des ersten Transistors (N1, P4) bzw. des zweiten Transistors (N2, P5) mit dem ersten Ausgangsanschluss (V_{A}) bzw. mit dem zweiten Ausgangsanschluss (V_{B}) der Resonanzschaltung verbunden ist, während der Steueranschluss jedes Transistors über einen Kopplungskondensator (C1, C3) mit dem ersten Stromanschluss des anderen Transistors verbunden ist,
**dadurch gekennzeichnet, dass** jeder Transistor des Paars zu einem als Diode geschalteten Transistor (N3, N4, P1, P6), durch den ein von einer Stromquelle (I1, I2) gelieferter Strom fließt, parallelgeschaltet ist, wobei jeder Transistor des Paars und der entsprechende als Diode geschaltete Transistor einen Stromspiegel bilden, um die Resonanzschaltung mit einem mittleren Strom zu beaufschlagen, derart, dass oszillierende Signale mit einer maximalen Amplitude, die von der Dimensionierung bestimmter Elemente der Schaltung abhängt, geliefert werden.

2. Oszillatorschaltung nach Anspruch 1, **dadurch gekennzeichnet, dass** sie eine Regelungsschleife für die Amplitude der oszillierenden Signale umfasst, in der sich der Stromwert der Stromquelle (I1, I2) jedes Stromspiegels in Abhängigkeit von dem erfassten Pegel der Amplitude der oszillierenden Signale ändert, wobei der Stromwert abnimmt bzw. zunimmt, wenn der Pegel der Amplitude der oszillierenden Signale zunimmt bzw. abnimmt.

3. Oszillatorschaltung nach Anspruch 2, **dadurch gekennzeichnet, dass** die Amplitudenregelungsschleife insbesondere zwei ohmsche Widerstände (R1, R2, R5, R6), die zwischen den Steueranschlüssen der Transistoren des Paars in Reihe geschaltet sind, und einen Filterungskondensator (Cm), dessen erste Elektrode direkt oder über eine Folgertransistor-Anordnung (P7, N7) mit dem Verbindungsknoten der zwei ohmschen Widerstände verbunden ist und dessen zweite Elektrode mit einem Anschluss auf hohem oder niedrigen Potential einer Spannungsquelle verbunden ist, umfasst, wobei ein Gleichtakt-Spannungspegel, der vom Amplitudenpegel der oszillierenden Signale abhängt, an der ersten Elektrode des Filterungskondensators über den Verbindungsknoten der ohmschen Widerstände abgegriffen wird, um den Stromwert der Stromquellen zu bestimmen.

4. Oszillatorschaltung nach Anspruch 3, **dadurch gekennzeichnet, dass** der Stromwert der Stromquellen in der Amplitudenregelungsschleife durch einen ohmschen Referenzwiderstand (R3) definiert ist, der mit einem Stromanschluss wenigstens eines Referenztransistors (N5, N6) verbunden ist, wobei ein Steueranschluss des Referenztransistors mit der ersten Elektrode des Filterungskondensators (Cm) verbunden ist, derart, dass der ohmsche Referenzwiderstand und der Referenztransistor zu dem Filterungskondensator parallelgeschaltet sind, wobei der Referenztransistor durch die Gleichtaktspannung, die durch den Filterungskondensator abgegriffen wird, vorgespannt wird.

5. Oszillatorschaltung nach einem der vorhergehenden Ansprüche, **dadurch gekennzeichnet, dass** die Resonanzschaltung (L1, L2, Cv) und das Paar kreuzgekoppelter Transistoren (N1, N2) zwischen einen Anschluss (V_{EXT}) mit hohem Potential und einen Anschluss mit niedrigem Potential einer regulierten Spannungsquelle in Reihe geschaltet sind, wobei der zweite Stromanschluss jedes Transistors des Paars und des entsprechenden als Diode geschalteten Transistors (N3, N4) direkt mit dem Anschluss auf hohem Potential oder mit dem Anschluss auf niedrigem Potential der regulierten Spannungsquelle verbunden ist, und dass die Resonanzschaltung zwei Induktivitäten (L1, L2) umfasst, die jeweils mit einem Ausgangsanschluss der entsprechenden Resonanzschaltung und mit dem Potentialanschluss, der zu dem Potentialanschluss, der den zweiten Stromanschluss der Transistoren verbindet, entgegengesetzt ist, verbunden ist, wobei das veränderliche kapazitive Element (Cv) zwischen die beiden Ausgangsanschlüsse der Resonanzschaltung geschaltet ist.

6. Oszillatorschaltung nach Anspruch 5, **dadurch gekennzeichnet, dass** das Paar kreuzgekoppelter Transistoren (N1, N2) sowie jeder als Diode geschalteter Transistor (N3, N4), der mit einem entsprechenden Transistor des Paars verbunden ist, Transistoren des Typs NMOS sind, deren Source direkt mit einem Anschluss auf niedrigem Potential einer regulierten Spannungsquelle verbunden ist, und dass der Referenztransistor (N5) ein NMOS-Transistor ist, dessen Source mit dem ohmschen Referenzwiderstand (R3) verbunden ist, der mit einem Anschluss auf niedrigem Potential einer Spannungsquelle verbunden ist, und dessen Drain einen Referenzstrom an einen als Diode geschalteten PMOS-Transistor (P1) eines zweiten Stromspiegels liefert, der mit einem Anschluss auf hohem Potential einer Versorgungsspannungsquelle (V_{DD}) verbunden ist, wobei zwei andere PMOS-Transistoren (P2, P3) des zweiten Stromspiegels zu dem als Diode geschalteten PMOS-Transistor parallelgeschaltet sind, derart, dass der Referenzstrom verdoppelt wird, um an die als Diode geschalteten NMOS-Transistoren jeweils einen Strom zu liefern, wobei der Wert des Stroms von dem erfassten Pegel der Amplitude der oszillierenden Signale abhängt.

7. Oszillatorschaltung nach einem der Ansprüche 1 bis 4, **dadurch gekennzeichnet, dass** sie ein erstes und ein zweites Paar kreuzgekoppelter Transistoren unterschiedlichen Typs umfasst, wobei der Steueranschluss jedes Transistors der zwei Paare über einen Kopplungskondensator (C1, C3, C5, C8) mit dem ersten Stromanschluss des anderen Transistors des Paars verbunden ist, und dass die Resonanzschaltung, die zwischen den zwei Ausgangsanschlüssen (V_{A,} V_{B}) eine zu dem kapazitiven Element (Cv) parallele Induktivität (L1) aufweist, zwischen den zwei Transistorpaaren (N1, N2, P4, P5) angeordnet ist, wobei der zweite Stromanschluss jedes Transistors des ersten Paars mit einem Anschluss (V_{SS}) auf niedrigem Potential verbunden ist, während der zweite Stromanschluss jedes Transistors des zweiten Paars mit einem Anschluss (V_{DD}) auf hohem Potential einer Versorgungsspannungsquelle verbunden ist.

8. Oszillatorschaltung nach Anspruch 7, **dadurch gekennzeichnet, dass** das erste Paar kreuzgekoppelter Transistoren (P4, P5) sowie jeder als Diode geschaltete Transistor (P1, P4), der mit einem entsprechenden Transistor des ersten Paars verbunden ist, Transistoren des Typs PMOS sind, deren Source direkt mit einem Anschluss (V_{DD}) auf hohem Potential der Versorgungsspannungsquelle verbunden ist, und dass das zweite Paar kreuzgekoppelter Transistoren Transistoren des Typs NMOS enthält, deren Source direkt mit einem Anschluss (V_{SS}) auf niedrigem Potential der Spannungsquelle verbunden ist.

9. Oszillatorschaltung nach Anspruch 8, **dadurch gekennzeichnet, dass** sie zwei parallelgeschaltete Referenztransistoren (N5, N6) umfasst, wobei die Referenztransistoren NMOS-Transistoren sind, deren Source mit dem ohmschen Referenzwiderstand (R3) verbunden ist, der mit einem Anschluss auf niedrigem Potential einer Spannungsquelle verbunden ist, und deren Drain jeweils einen Referenzstrom an einen entsprechenden als Diode geschalteten PMOS-Transistor (P1, P6) liefert, dass der Verbindungsknoten der zwei ohmschen Widerstände (R5, R6), die zwischen den Gates der Transistoren des ersten Paars in Reihe geschaltet sind, mit einem Gate eines PMOS-Folgertransistors verbunden ist, dessen Source direkt mit dem Anschluss auf hohem Potential der Spannungsquelle verbunden ist und dessen Drain mit einem als Diode geschalteten NMOS-Folgertransistor (N7) verbunden ist, wobei die Source dieses NMOS-Transistors direkt mit dem Anschluss auf niedrigem Potential der Spannungsquelle verbunden ist, dass der Drain und das Gate des NMOS-Folgertransistors mit der ersten Elektrode des Filterungskondensators (Cm) und mit den Gates der Referenztransistoren (N5, N6) verbunden sind und dass zwei weitere ohmsche Widerstände (R1, R2) zwischen den Steueranschlüssen der NMOS-Transistoren des zweiten Paars in Reihe geschaltet sind, wobei der Verbindungsknoten dieser ohmschen Widerstände mit der ersten Elektrode des Filterungskondensators (Cm) verbunden ist, um dazu zu dienen, die NMOS-Transistoren des zweiten Paars vorzuspannen.

10. Oszillatorschaltung nach einem der vorhergehenden Ansprüche, **dadurch gekennzeichnet, dass** jeder Kopplungskondensator (C1, C3, C5, C6) der Steueranschlüsse der Transistoren jedes Paars einen Teil eines kapazitiven Teilers pro Transistor jedes Paars bildet, um die Spannung der oszillierenden Signale, die an die Steueranschlüsse der Transistoren jedes Paars zu liefern sind, zu teilen.
